# EUROPÄISCHE PATENTSCHRIFT

(11) **EP 4 352 496 B1**
(45) Veröffentlichungstag und Bekanntmachung des Hinweises auf die Patenterteilung: **14.01.2026**
(21) Anmeldenummer: 22729408.9
(22) Anmeldetag: 07.06.2022
(51) Int. Cl.: G01N 21/95, G01Q 20/00, G02B 21/26, H01J 37/20, G01B 11/02, G01B 5/00, H01L 21/66, G01Q 30/20

(54) **VERFAHREN UND VORRICHTUNG ZUR STÖRGRÖSSENKOMPENSATION BEI DER POSITIONIERUNG EINES PROBENTRÄGERS**
METHOD AND DEVICE FOR THE COMPENSATION OF DISTURBANCES DURING THE POSITIONING OF A SAMPLE CARRIER
PROCÉDÉ ET DISPOSITIF DE COMPENSATION DES GRANDEURS PERTURBATRICES LORS DU POSITIONNEMENT D'UN PORTE-ÉCHANTILLON

(30) Priorität: 07.06.2021 AT 504582021
(43) Veröffentlichungstag der Anmeldung: 17.04.2024
(73) Patentinhaber: TECHNISCHE UNIVERSITÄT WIEN, 1040 Wien (AT)
(72) Erfinder: VALTINER, Markus, 1180 Wien (AT); SCHWENZFEIER, Kai Alexander, 1030 Wien (AT)
(74) Vertreter: SONN Patentanwälte GmbH & Co KG
(86) Internationale Anmeldenummer: PCT/AT2022/060187
(87) Internationale Veröffentlichungsnummer: WO 2022/256853

(56) Entgegenhaltungen:
- WO-A1-2019/068601
- DE-A1- 102019 215 217
- ANONYMOUS: "Analog Piezo Nanopositioning Controllers", PIEZO NANOPOSITIONING CONTROLLERS, 2 January 2008 (2008-01-02), pages 1 - 18, XP055955893, Retrieved from the Internet <URL:https://www.physikinstrumente.com/en/> [retrieved on 20220829]

## Beschreibung

Die Erfindung betrifft ein Verfahren und eine Vorrichtung zur Störgrößenkompensation bei der Positionierung eines Probenträgers.

Die genaue Positionierung eines Probenträgers ist z.B. bei sondenmikroskopischen Messungen, in der Halbleitertechnologie bei der Einrichtung von Maske und Wafer und der Einkristalltomographie erforderlich.

Sondenmikroskopische Messungen verwenden spezielle Sonden (z.B. Rasterkraftmikroskopie: feine Nadel; Rastertunnelmikroskopie: feine, elektrisch leitende Drahtspitze; optische Pinzette: Partikel im Brennpunkt eines fokussierten Lasers), um deren Wechselwirkung mit einer Probe mit hoher örtlicher Auflösung von bis zu 0,01 nm zu vermessen und/oder bildgebend darzustellen.

Die Wechselwirkung der Sonde zur Probe hängt von der relativen Position der Sonde zur Probe ab. Alle Geräte dieser Klasse zeigen charakteristische Drifterscheinungen, welche die relative Position der Sonde zur Probe nicht-linear verändern. Drift wird durch thermische Expansion/Kontraktion der strukturellen Bauteile der Apparate, oder durch mechanische Relaxation gefügter Bauteilelemente verursacht. Die mit dem Drift einhergehende Ungenauigkeit der Sondenposition tritt in allen drei Raumrichtungen auf, stellt eine Störgröße bei der Positionierung des Sondenträgers bzw. der Sonde dar und liegt je nach Bauweise um 4-5 Größenordnung pro Minute über der theoretisch erreichbaren Auflösung von 0,01 nm. Damit ist ein hochexaktes zeitinvariantes Positionieren, sowie ein reproduzierbares Messen an einer in Echtzeit nanometergenau definierten Position über Zeiträume von Minuten bis Stunden nicht möglich.

Aus dem Stand der Technik sind zur Kompensation dieser Drifteffekte verschiedene Methoden bekannt: Bauliche Maßnahmen umfassen beispielsweise die Verwendung von Konstruktionsmaterialien mit geringer thermischer Ausdehnung, Minimierung von Verbindungen auf Basis von Haftreibung oder symmetrischen Aufbau. Andere Maßnahmen umfassen weiterhin Isolation von Schall, Stabilisierung gegenüber Temperaturänderungen oder Vermeidung von Schwingungen durch bauliche Maßnahmen des Raums, der das Gerät beherbergt. Zu weniger aufwändigen Methoden gehören Softwarelösungen wie Adaptionen im Messprotokoll, die Redundanzen und bekannte Marker enthalten, sowie softwaregestützte Korrekturen nach der Messung. Methoden der Echtzeitkorrektur werden technisch über zusätzliche Probenmarker realisiert, die mittels zusätzlicher Sensorsysteme geortet werden können.

Nachteilig an vorgenannten Methoden ist, dass sie sehr kostspielig (bauliche und nicht-bauliche Maßnahmen) sind, die Messzeit so erhöhen können, dass zeitkritische Messprobleme ausgeschlossen werden (zusätzliche Redundanzen), oder bewirken, dass die Messung nicht mehr der Messaufgabe entspricht, weil die gewollte relative Position nicht gehalten werden kann (nachträgliche Korrektur). Ein weiterer Nachteil der etablierten Korrekturmethoden in Echtzeit mittels Probenmarkern besteht darin, dass die Lösung speziell in die Messmethode eingefügt und die Probe hierauf angepasst und adaptiert werden muss. Dieser Schritt ist nicht allgemein gültig, d.h. nicht alle Probensysteme erlauben das Aufbringen von Markern und potentieller Drift des Detektionssystems an sich wird hierbei ignoriert.

Diese Probleme treten allgemein bei der genauen Positionierung von Probenträgern auf.

Die US 2013/0098274 A1 zeigt eine Probenvorrichtung, bei der mit Laserinterferometern die Entfernung zu einem Probentisch in x-Richtung und in y-Richtung ermittelt wird. Nachteiligerweise kann damit jedoch eine thermische Expansion des Probentisches nicht kompensiert werden, da diese nicht ermittelt werden kann. Weiters zeigt WO 2019/068601 A1 eine Objekttischvorrichtung für ein Elektronenoptiksystem. Das verwendete Interferometer-Positionsmesssystem umfasst einen ersten und zweiten Interferometersensor, die schräg gegenüberliegend angeordnet sind und Messstrahlen mit sowohl horizontalen (x-Richtung) als auch vertikalen (z-Richtung) Komponenten verwenden, um Relativverschiebungen zwischen einem Objekttisch und einem Elektronenoptiksystem zu messen. Ein dritter Interferometersensor ist zur Bestimmung der Position des Objekttisches in y-Richtung angeordnet. Das Dokument "Analog Piezo Nanopositioning Controllers" in Piezo Nanopositioning Controllers zeigt eine Kontrollvorrichtung für einen Kippspiegel mit differentieller Positionsbestimmung für zwei Achsen. DE 10 2019 215217 A1 zeigt ein Messverfahren zur Ermittlung der Position und/oder Orientierung eines optischen Elements.

Die Aufgabe der Erfindung liegt darin, zumindest einen der Nachteile des Stands der Technik zu lindern oder zu beseitigen. Insbesondere liegt der Erfindung die Aufgabe zugrunde, ein Verfahren und eine Vorrichtung bereitzustellen, bei dem/der methodenunabhängig Störgrößen (insbesondere thermischer Drift und thermische Expansion) in Bezug auf die Positionierung eines Probenträgers relativ zu einem Sensorträger (insbesondere in Echtzeit) kompensiert werden, vorzugsweise ohne dabei eine besondere Beschaffenheit der Probe zu benötigen.

Diese Aufgabe wird gelöst durch ein Verfahren zur Störgrößenkompensation bei der Positionierung eines Probenträgers (relativ zu einem Sensorträger) nach Anspruch 1, insbesondere bei der Sondenmikroskopie, das die Schritte aufweist:
Messung einer Distanz mit einem ersten Distanzsensor des Sensorträgers zu einer ersten Seite des Probenträgers und einer Distanz mit einem zweiten Distanzsensor des Sensorträgers zu einer der ersten Seite gegenüberliegenden zweiten Seite des Probenträgers, wobei die Distanzen im Wesentlichen parallel zu einer ersten Achse bestimmt werden;
Messung einer Distanz mit einem dritten Distanzsensor des Sensorträgers zu einer dritten Seite des Probenträgers und einer Distanz mit einem vierten Distanzsensor des Sensorträgers zu einer der dritten Seite gegenüberliegenden vierten Seite des Probenträgers, wobei die Distanzen im Wesentlichen parallel zu einer von der ersten Achse verschiedenen zweiten Achse bestimmt werden;
Bestimmen der Position und der Ausdehnung des Probenträgers entlang der ersten Achse aus den Distanzen parallel zu der ersten Achse und/oder Bestimmen der Position und der Ausdehnung des Probenträgers entlang der zweiten Achse aus den Distanzen parallel zu der zweiten Achse;
Positionieren des Probenträgers relativ zum Sensorträger mit einem Piezopositionierer.

Weiters wird die Aufgabe gelöst durch eine Vorrichtung zur Störgrößenkompensation bei der Positionierung eines Probenträgers (relativ zu einem Sensorträger) nach Anspruch 11, wobei die Vorrichtung aufweist:
- den Probenträger;
- einen Sensorträger mit
   einem ersten Distanzsensor zur Messung der Distanz zu einer ersten Seite des Probenträgers und einem zweiten Distanzsensor zur Messung der Distanz zu einer der ersten Seite gegenüberliegenden zweiten Seite des Probenträgers,
   einem dritten Distanzsensor zur Messung der Distanz zu einer dritten Seite des Probenträgers und einem vierten Distanzsensor zur Messung der Distanz zu einer der dritten Seite gegenüberliegenden vierten Seite des Probenträgers,
   wobei der erste und der zweite Distanzsensor zur Bestimmung der Distanzen im Wesentlichen parallel zu einer ersten Achse eingerichtet sind und der dritte und der vierte Distanzsensor zur Bestimmung der Distanzen im Wesentlichen parallel zu einer von der ersten Achse verschiedenen zweiten Achse eingerichtet sind; und
- einen Piezopositionierer, der den Probenträger trägt
- eine Kontrolleinheit, wobei die Vorrichtung dazu eingerichtet ist, das erfindungsgemäße Verfahren (gemäß einer der Ausführungsformen) durchzuführen.

Durch die Distanzmessung zu zwei gegenüberliegenden Seiten des Probenträgers kann sowohl eine Verschiebung, z.B. aufgrund von thermischer Relaxation, als auch eine Ausdehnung des Probenträgers festgestellt werden, ohne dass dafür weitere Maßnahmen wie spezielle Markierungen notwendig sind. Mit dem ersten und zweiten Distanzsensor werden diese in Richtung der ersten Achse ermittelt und mit dem dritten und vierten Distanzsensor in Richtung der zweiten Achse. Diese Messung kann vorteilhafterweise in Echtzeit erfolgen. Unter Störgrößen werden insbesondere (thermischer) Drift und mechanische Vibration, Schwingungen und/oder Verformungen verstanden.

Die Messung bzw. die Bestimmung der Distanz mit dem ersten Distanzsensor erfolgt vorzugsweise in die entgegengesetzte Richtung zur Messung bzw. zur Bestimmung der Distanz mit dem zweiten Distanzsensor. Die Messung bzw. die Bestimmung der Distanz mit dem dritten Distanzsensor erfolgt vorzugsweise in die entgegengesetzte Richtung zur Messung bzw. zur Bestimmung der Distanz mit dem vierten Distanzsensor. Vorzugsweise erfolgt die Messung mit dem ersten Distanzsensor und mit dem zweiten Distanzsensor entlang der ersten Achse. Vorzugsweise erfolgt die Messung mit dem dritten Distanzsensor und mit dem vierten Distanzsensor entlang der zweiten Achse. Der erste, zweite, dritte und vierte Distanzsensor sind dazu eingerichtet, eine Distanz bevorzugt auf weniger als 10 nm, besonders bevorzugt auf weniger als 1 nm, noch mehr bevorzugt auf weniger als 0,1 nm, genau zu messen. Unter Distanzsensoren werden Abstandssensoren verstanden, die einen Abstand zwischen einem Sensorkopf und einem Ziel bestimmen können, insbesondere mit einer Genauigkeit von vorzugsweise zwischen 10⁻⁸ und 10⁻¹² m. Nach einer Kalibrationsphase können optional relative Änderungen der Messgrößen anstelle der Messgrößen selbst verwendet werden. Unter der Distanz zur jeweiligen Seite wird insbesondere der Abstand zwischen dem jeweiligen Distanzsensor und der jeweiligen Seite verstanden. Der Sensorträger trägt den ersten Distanzmesser, zweiten Distanzmesser, dritten Distanzmesser und vierten Distanzmesser. Der erste, zweite, dritte und vierte Distanzmesser messen somit jeweils die Distanz von einem Punkt des Sensorträgers zu einem Punkt des Probenträgers. Der erste und zweite Distanzsensor messen insbesondere die Distanz zu einander gegenüberliegenden Kanten des Probenträgers. Die Punkte des Probenträgers zu denen jeweils die Distanzen gemessen werden, können besonders präpariert sein, beispielsweise ein reflektierendes Material aufweisen. Die erste, zweite, dritte und vierte Seite sind vorzugsweise jeweils voneinander verschieden. Bevorzugt liegt die dritte Seite zwischen der ersten und der zweiten Seite und/oder die vierte Seite zwischen der zweiten und der ersten Seite.

Das Positionieren des Probenträgers mit dem Piezopositionierer erfolgt vorzugsweise auf Grundlage der vom ersten, zweiten, dritten und vierten Distanzsensor ermittelten Distanzen, wobei

Störgrößen kompensiert werden. Vorzugsweise erfolgt die Positionierung derart, dass ein angenommener Mittelpunkt des Probenträgers, der auf Grundlage der jeweils von beiden Seiten gemessenen Distanzen bestimmt wird, an einen vorgegebenen (gewünschten) Mittelpunkt bewegt wird.

Aus den jeweiligen Distanzsensoren, die zu gegenüberliegenden Seiten des Probenträgers messen und die einander gegenüberliegen, werden die relative Position und relative thermische Ausdehnung von Sensorträger und Probenträger, und somit, wenn diese eine Sonde bzw. eine Probe tragen, auch der Sonde und Probe selbst, bestimmt.

Es kann eine beliebige tragende Konstruktion vorgesehen sein, die den Sensorträger und den Piezopositionierer trägt, wobei der Piezopositionierer den Probenträger trägt. Der Sensorträger weist vorzugsweise eine Apertur auf, durch die vorzugsweise eine Sonde geführt werden kann bzw. geführt sein kann.

Die Messung der Distanz mit dem ersten Distanzsensor des Sensorträgers zur ersten Seite des Probenträgers und der Distanz mit dem zweiten Distanzsensor des Sensorträgers zur zweiten Seite des Probenträgers erfolgt vorzugsweise gleichzeitig. Die Messung der Distanz mit dem dritten Distanzsensor des Sensorträgers zur dritten Seite des Probenträgers und der Distanz mit dem vierten Distanzsensor des Sensorträgers zur vierten Seite des Probenträgers erfolgt vorzugsweise gleichzeitig. Vorzugsweise erfolgen die Messungen der Distanzen mit dem ersten, zweiten, dritten und vierten Distanzsensor gleichzeitig.

Darunter, dass die erste und die zweite Achse verschieden voneinander sind, wird verstanden, dass die erste und die zweite Achse nicht parallel zueinander sind.

Es ist vorgesehen, dass aus den Distanzen parallel zu der ersten Achse die Position und die Ausdehnung des Probenträgers entlang (d.h. in Richtung) der ersten Achse bestimmt werden und/oder aus den Distanzen parallel zu der zweiten Achse die Position und die Ausdehnung entlang (d.h. in Richtung) der zweiten Achse bestimmt werden. Bevorzugt erfolgt das Positionieren des Probenträgers aufgrund der bestimmten Position(en) und Richtung(en) entlang der ersten und/oder zweiten Achse.

Es ist vorteilhaft, wenn das Verfahren weiter aufweist:
Messung einer Distanz zum Probenträger mit einem fünften Distanzmesser des Sensorträgers, wobei die Distanz im Wesentlichen parallel zu einer dritten Achse bestimmt wird, die von der ersten Achse und der zweiten Achse verschieden ist, wobei vorzugsweise die Position des Probenträgers entlang der dritten Achse bestimmt wird. Wenn mit dem ersten bis vierten Distanzsensor die Position und Ausdehnung beispielsweise in jeweils horizontaler Richtung bestimmt werden, kann mit dem fünften Distanzmesser auch die Position in vertikaler Richtung ermittelt werden. Da üblicherweise die Probe auf dem Probenträger angeordnet ist und sich in Richtung der ersten Achse und der zweiten Achse auf dem Probenträger erstreckt, muss die Ausdehnung des Probenträgers in Richtung der dritten Achse nicht notwendigerweise bestimmt werden. Diese beeinflusst üblicherweise die Position einer am Probenträger vorgesehenen Probe und einer Sonde nicht. Somit kann mit dem ersten bis fünften Distanzsensor eine absolute Positionierung des Probenträgers erzielt werden. Die im Zusammenhang mit dem ersten bis vierten Distanzsensor erwähnten bevorzugten Ausgestaltungen können auch für den fünften Distanzsensor vorgesehen sein. Vorzugsweise erfolgt die Positionierung des Probenträgers auch auf Grundlage der vom fünften Distanzsensor ermittelten Distanz. Die Messung der Distanz mit dem fünften Distanzsensor erfolgt vorzugsweise gleichzeitig mit den Messungen der Distanzen mit dem ersten, zweiten, dritten und/oder vierten Distanzsensor.

Darunter, dass die dritte Achse von der ersten Achse und der zweiten Achse verschieden ist, wird verstanden, dass die dritte Achse und die erste Achse nicht parallel zueinander sind und dass die dritte Achse und die zweite Achse nicht parallel zueinander sind.

Es ist vorteilhaft, wenn das Verfahren weiter aufweist:
Messung einer Distanz zum Probenträger mit einem sechsten Distanzmesser des Sensorträgers und mit einem siebten Distanzmesser des Sensorträgers, wobei die Distanzen im Wesentlichen parallel zu der dritten Achse bestimmt werden, wobei vorzugsweise eine Verkippung um eine erste Kippachse des Probenträgers aus den vom sechsten Distanzmesser und vom siebten Distanzmesser bestimmten Distanzen bestimmt wird und/oder eine Verkippung um eine zweite Kippachse des Probenträgers aus den vom fünften Distanzmesser, sechsten Distanzmesser und siebten Distanzmesser bestimmten Distanzen bestimmt wird. Es kann z.B. aus einer relativen Distanzänderung gemessen vom sechsten und siebten Distanzsensor ein Kippwinkel des Probenträgers um die erste Kippachse bestimmt werden und/oder aus der relativen Distanzänderung gemessen vom fünften Distanzsensor und dem Mittel des sechsten und siebten Distanzsensors ein Kippwinkel (Neigewinkel) entlang der zweiten Kippachse bestimmt werden. Die erste und die zweite Kippachse sind vorzugsweise orthogonal zueinander. Vorzugsweise ist die erste Kippachse parallel zur ersten Achse und die zweite Kippachse parallel zur zweiten Achse. Vorzugsweise sind der sechste und der siebte Distanzsensor in eine Richtung orthogonal zur ersten Kippachse (bzw. zu einer Parallelen der ersten Kippachse) voneinander beabstandet. Vorzugsweise liegen die Achsen, entlang derer der fünfte, sechste und siebte Distanzsensor die Entfernungen bestimmen, nicht in einer Ebene. Vorzugsweise messen der fünfte, sechste und siebte Distanzsensor die Distanzen jeweils in die gleiche Richtung (d.h. zur gleichen Seite des Probenträgers). Die im Zusammenhang mit dem ersten bis fünften Distanzsensor beschriebenen bevorzugten Ausführungsformen können auch im Zusammenhang mit dem sechsten und/oder siebten Distanzsensor vorgesehen sein. Vorteilhafterweise erfolgt die Positionierung des Probenträgers mit dem Piezopositionierer auch auf Grundlage der vom sechsten und siebten Distanzsensor gemessenen Distanz. Vorzugsweise erfolgt die Positionierung des Probenträgers mit dem Piezopositionierer auf Grundlage einer ermittelten Position in Richtung der dritten Achse und/oder auf Grundlage eines ermittelten Kippwinkels um die erste Kippachse und/oder auf Grundlage eines ermittelten Kippwinkels um die zweite Kippachse. Die Messungen der Distanzen mit dem fünften Distanzsensor, dem sechsten Distanzsensor und dem siebten Distanzsensor erfolgt vorzugsweise gleichzeitig. Die Messungen der Distanzen mit dem ersten, zweiten, dritten, vierten, fünften, sechsten und siebten Distanzsensor erfolgen vorzugsweise gleichzeitig.

Es ist vorteilhaft, wenn eine Regelkreissteuerung erfolgt, wobei mit dem Piezopositionierer Störgrößen (insbesondere thermischer Drift und/oder thermische Ausdehnung) in der Positionierung des Probenträgers kompensiert werden auf Grundlage der mit dem ersten Distanzsensor und mit dem zweiten Distanzsensor bestimmten Distanzen parallel zu der ersten Achse, insbesondere der bestimmten Position und Ausdehnung des Probenträgers entlang der ersten Achse, und der mit dem dritten Distanzsensor und mit dem vierten Distanzsensor bestimmten Distanzen parallel zu der zweiten Achse, insbesondere der bestimmten Position und Ausdehnung des Probenträgers entlang der zweiten Achse, und vorzugsweise der mit dem fünften Distanzsensor bestimmten Distanz parallel zu der dritten Achse, insbesondere der bestimmten Position des Probenträgers entlang der dritten Achse, und optional der mit dem fünften Distanzsensor und/oder sechsten Distanzsensor und/oder siebten Distanzsensor bestimmten Distanzen parallel zu der dritten Achse.

Es ist vorteilhaft, wenn die Regelkreissteuerung umfasst, dass eine Verkippung des Probenträgers um die erste Kippachse und/oder die zweite Kippachse (die insbesondere mit dem fünften, sechsten und siebten Distanzsensor bestimmt wurde) vom Piezopositionierer kompensiert werden. Mit dem Regelkreis wird der Probenträger vorzugsweise auf einer vorbestimmten Position und bevorzugt einer vorbestimmten Verkippung gebracht bzw. gehalten.

Es ist vorteilhaft, wenn die erste Achse im Wesentlichen orthogonal zur zweiten Achse ist und vorzugsweise die erste Achse im Wesentlichen orthogonal zur dritten Achse ist und vorzugsweise die zweite Achse (y) im Wesentlichen orthogonal zur dritten Achse (z) ist. Insbesondere sind die erste Achse und die zweite Achse und vorzugsweise die dritte Achse nicht parallel zueinander.

Es ist vorteilhaft, wenn die erste Achse und die zweite Achse im Wesentlichen horizontal verlaufen und vorzugsweise die dritte Achse im Wesentlichen vertikal verläuft.

Es ist vorteilhaft, wenn der erste Distanzsensor, der zweite Distanzsensor, der dritte Distanzsensor und der vierte Distanzsensor (und vorzugsweise der fünfte Distanzsensor, und vorzugsweise der sechste und der siebte Distanzsensor) jeweils mit einer Erfassungsrate von zwischen 0,2 Hz und 10 MHz, vorzugsweise von zwischen 1 Hz und 1 MHz, betrieben werden und die Positionierung des Probenträgers durch den Piezopositionierer mit einer Ansteuerungsrate von zwischen 0,2 Hz und 10 MHz, vorzugsweise von zwischen 1 Hz und 1 MHz, erfolgt. Somit erfolgt die Störgrößenkompensation praktisch in Echtzeit.

Es ist vorteilhaft, wenn der Probenträger eine Probe trägt und der Sensorträger eine Sonde zur Wechselwirkung mit der Probe trägt. Vorteilhafterweise ist das Verfahren Teil eines Verfahrens zur Sondenmikroskopie, insbesondere zur Rasterkraftmikroskopie, Rastertunnelmikroskopie oder als optische Pinzette. Diese können mit dem erfindungsgemäßen Verfahren mit besonders hoher Genauigkeit und Qualität durchgeführt werden, da Störgrößen besonders gut kompensiert werden.

Bezugnehmend auf die erfindungsgemäße Vorrichtung ist es vorgesehen, dass die Vorrichtung eine Kontrolleinheit aufweist, wobei die Vorrichtung dazu eingerichtet ist, das erfindungsgemäße Verfahren (gemäß einer der Ausführungsformen) durchzuführen. Die Kontrolleinheit ist dazu eingerichtet, die restlichen Komponenten der Vorrichtung zur Durchführung des erfindungsgemäßen Verfahrens (gemäß einer der Ausführungsformen) zu steuern bzw. von diesen Signale zu empfangen.

Es ist vorteilhaft, wenn der erste Distanzsensor, zweite Distanzsensor, dritte Distanzsensor und/oder vierte Distanzsensor (und vorzugsweise der fünfte, sechste und/oder siebte Distanzsensor) jeweils ein kapazitativer Distanzsensor oder ein interferometrischer Distanzsensor sind. Mit diesen kann eine besonders genaue Messung und damit Störgrößenkompensation erzielt werden.

Es ist vorteilhaft, wenn der erste Distanzsensor, zweite Distanzsensor, dritte Distanzsensor und/oder vierte Distanzsensor (und vorzugsweise der fünfte, sechste und/oder siebte Distanzsensor) jeweils ein laserinterferometrischer Distanzsensor sind. Vorzugsweise weist der Probenträger reflektierende Flächen auf, auf die Laserstrahlen der Distanzsensoren jeweils ausgerichtet sind.

Es ist vorteilhaft, wenn die Vorrichtung aufweist:
einen fünften Distanzsensor zur Messung der Distanz zum Probenträger,
vorzugsweise einen sechsten Distanzsensor zur Messung der Distanz zum Probenträger,
vorzugsweise einen siebten Distanzsensor zur Messung der Distanz zum Probenträger,
wobei der fünfte Distanzsensor, vorzugsweise der sechste Distanzsensor und vorzugsweise der siebte Distanzsensor zur Bestimmung der Distanzen im Wesentlichen parallel zu einer dritten Achse eingerichtet sind, die von der ersten Achse und der zweiten Achse verschieden ist.

Die Erfindung wird nachfolgend anhand von besonders bevorzugten Ausführungsbeispielen, auf die sie jedoch nicht beschränkt sein soll, und unter Bezugnahme auf die Zeichnungen noch weiter erläutert.
Fig. 1 zeigt schematisch eine bevorzugte Ausführungsform der Vorrichtung zur Störgrößenkompensation von schräg oben.
Fig. 2 zeigt schematisch dieselbe Ausführungsform der Vorrichtung wie Fig. 1 in einem Schnitt entlang der Ebene AA in Fig. 1.
Fig. 3 zeigt schematisch dieselbe Ausführungsform der Vorrichtung wie Fig. 1 in einem Schnitt entlang der Ebene BB in Fig. 1.
Fig. 4 veranschaulicht in einem Flussdiagramm eine bevorzugte Ausführungsform des Verfahrens zur Störgrößenkompensation.

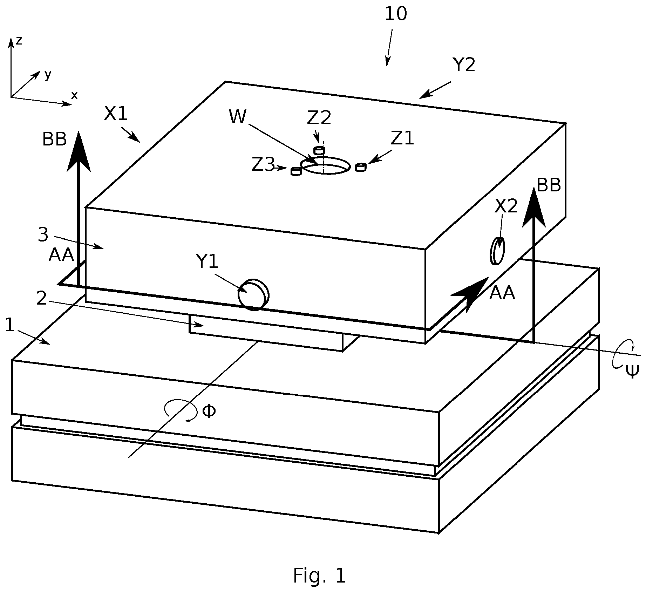

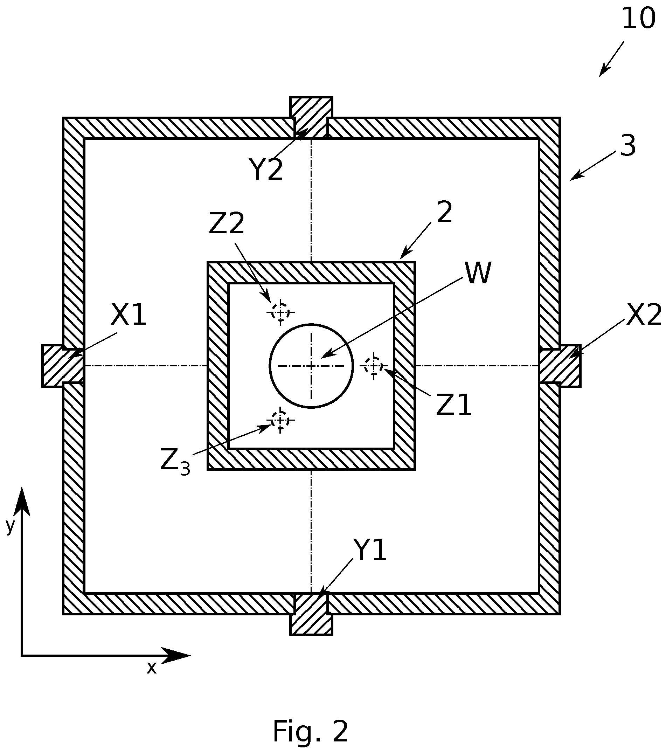

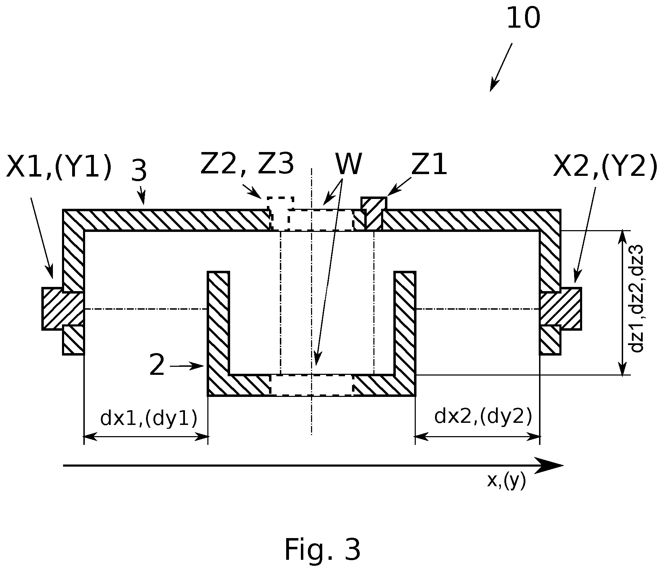

Die Figuren 1, 2 und 3 zeigen schematisch eine bevorzugte Ausführungsform einer Vorrichtung 10 zur Störgrößenkompensation bei der Positionierung eines Probenträgers 2. Fig. 1 zeigt die Vorrichtung 10 von schräg oben, Fig. 2 zeigt die Vorrichtung 10 in einer Schnittdarstellung entlang der Ebene AA in Fig. 1 und Fig. 3 zeigt die Vorrichtung 10 in einer Schnittdarstellung entlang der Ebene BB in Fig. 1. In Fig. 3 sind in Klammern auch die Bezugszeichen für einen Schnitt durch eine auf AA und BB orthogonale Ebene in Fig. 1 eingezeichnet.

Die Vorrichtung 10 weist den Probenträger 2, einen Sensorträger 3 und einen Piezopositionierer 1, der den Probenträger 2 trägt, auf. In Fig. 1 bilden eine erste Achse x, eine zweite Achse y und eine dritte Achse z ein orthogonales Koordinatensystem. Der Sensorträger 3 umgibt den Probenträger 2 in Richtung der ersten Achse x und der zweiten Achse y zumindest teilweise.

Der Sensorträger 3 weist einen ersten Distanzsensor X1 zur Messung der Distanz dx1 zu einer ersten Seite des Probenträgers 2 und einen zweiten Distanzsensor X2 zur Messung der Distanz dx2 zu einer der ersten Seite gegenüberliegenden zweiten Seite des Probenträgers 2 auf. Weiters weist der Sensorträger 3 einen dritten Distanzsensor Y1 zur Messung der Distanz dy1 zu einer dritten Seite des Probenträgers 2 und einen vierten Distanzsensor Y2 zur Messung der Distanz dy2 zu einer der dritten Seite gegenüberliegenden vierten Seite des Probenträgers 2 auf. Der erste und der zweite Distanzsensor X1, X2 sind zur Bestimmung der Distanzen dx1, dx2 im Wesentlichen parallel zu der ersten Achse x eingerichtet und der dritte und der vierte Distanzsensor Y1, Y2 sind zur Bestimmung der Distanzen dy1, dy2 im Wesentlichen parallel zu der zweiten Achse y eingerichtet. Dabei misst der erste Distanzsensor X1 in die entgegengesetzte Richtung zum zweiten Distanzsensor X2 und der dritte Distanzsensor Y1 in die entgegengesetzte Richtung zum vierten Distanzsensor Y2. Durch die Messung jeweils von beiden Seiten kann sowohl thermischer Drift als auch thermische Ausdehnung in Richtung der ersten Achse x und in Richtung der zweiten Achse y erkannt und kompensiert werden.

Der Sensorträger 3 weist weiter einen fünften Distanzsensor Z1 zur Messung der Distanz dz1 zum Probenträger 2, einen sechsten Distanzsensor Z2 zur Messung der Distanz dz2 zum Probenträger 2 und einen siebten Distanzsensor Z3 zur Messung der Distanz dz3 zum Probenträger 2 auf. Der fünfte Distanzsensor Z1, der sechste Distanzsensor Z2 und der siebte Distanzsensor Z3 sind zur Bestimmung der Distanzen dz1, dz2, dz3 im Wesentlichen parallel zu der dritten Achse z eingerichtet. Mit diesen kann sowohl die vertikale Position des Probenträgers 2 relativ zum Sensorträger 3 und die Verkippung bzw. Neigung des Probenträgers 2 ermittelt werden. Insbesondere werden die Distanzen dz2, dz3 im Wesentlichen parallel zu der dritten Achse z bestimmt, wobei eine Verkippung um eine erste Kippachse Ψ des Probenträgers 2 aus den vom sechsten Distanzmesser Z2 und vom siebten Distanzmesser Z3 bestimmten Distanzen dz2, dz3 bestimmt wird und eine Verkippung um eine zweite Kippachse Φ des Probenträgers 2 aus den vom fünften Distanzmesser Z1, sechsten Distanzmesser Z2 und siebten Distanzmesser Z3 bestimmten Distanzen dz1, dz2, dz3 bestimmt wird. Die Sensoren sind somit in Gruppen und Untergruppen nach Aufgabenstellung und Raumrichtung eingeteilt. Die horizontalen Sensoren X1, X2, Y1, Y2 dienen der simultanen Echtzeitbestimmung von relativer lateraler Position des Probenträgers 2 zum Sensorträger 3 sowie der aktuellen thermischen Expansion des Probenträgers 2. Die vertikalen Sensoren Z1, Z2, Z3 dienen der simultanen Echtzeitbestimmung der relativen vertikalen Position des Probenträgers 2 relativ zum Sensorträger 3 sowie der relativen Verkippung des Probenträgers 2. Hierdurch ist eine zeitlich konstante absolute Positionierung von Probenträger 2 und Sensorträger 3 zueinander in Echtzeit gewährleistet.

Das von der ersten Achse x, zweiten Achse y und dritten Achse z gebildete Koordinatensystem entspricht vorzugsweise dem Koordinatensystem des Piezopositionierers 1. Erfindungsgemäß werden aus Sensoren, die sich paarweise gegenüber stehen, die relative Position von Sensorträger 3 und Probenträger 2, und damit ggf. von einer Sonde und einer Probe selbst, relative Position und relative thermische Ausdehnung bestimmt.

Die gemessene Distanz dz1, dz2, dz3 der vertikalen Distanzsensoren Z1, Z2, Z3 läuft vorzugsweise der z-Achse des Piezopositionierers 1 entgegen und wird entsprechend korrigiert. Aus der relativen Distanzänderung von dz2 und dz3 wird der Kippwinkel um die erste Kippachse Ψ bestimmt, während aus der relativen Distanzänderung von dz1 und dem Mittel zwischen dz2 und dz3 der Neigewinkel um die zweite Kippachse Φ bestimmt wird. Vorzugsweise verfügt der verwendete Piezopositionierer über Kipp- und Neigefreiheitsgrade, sodass eine Verkippung zwischen Probenträger 2 und Sensorträger 3 mittels der ersten Kippachse Ψ und der zweiten Kippachse Φ sowohl kontrolliert als auch korrigiert wird.

Der Sensorträger 3 und der Probenträger 2 weisen jeweils vorzugsweise eine Apertur W auf, durch die beispielsweise eine Sonde geführt werden kann. Zusätzlich zu der Bestimmung der vertikalen relativen Position in Richtung der ersten Achse x und der zweiten Achse y besteht die Möglichkeit einer langsameren Referenzmessung mittels Weißlichtinterferometrie über den Pfad der Aperturen W an einem Probensystem.

Die Störgrößenkompensation erfolgt vorzugsweise in einer Regelkreissteuerung, wobei mit dem Piezopositionierer 1 Störgrößen in der Positionierung des Probenträgers 2 (d.h. Abweichungen des Probenträgers 2 von einer vorbestimmten/gewünschten Position) kompensiert (d.h. durch Bewegung des Probenträgers 2 mit dem Piezopositionierer 1 relativ zum Sensorträger 3 ausgeglichen) werden auf Grundlage der mit dem ersten Distanzsensor X1 und mit dem zweiten Distanzsensor X2 bestimmten Distanzen dx1, dx2 parallel zu der ersten Achse x, insbesondere der bestimmten Position und Ausdehnung des Probenträgers 2 entlang der ersten Achse x, und der mit dem dritten Distanzsensor Y1 und mit dem vierten Distanzsensor Y2 bestimmten Distanzen dy1, dy2 parallel zu der zweiten Achse y, insbesondere der bestimmten Position und Ausdehnung des Probenträgers 2 entlang der zweiten Achse y, und der mit dem fünften Distanzsensor Z1 und/oder sechsten Distanzsensor Z2 und/oder siebten Distanzsensor Z3 bestimmten Distanzen dz1, dz2, dz3 parallel zu der dritten Achse x. Weiters umfasst die Regelkreissteuerung, dass eine Verkippung des Probenträgers 2 um die erste Kippachse Ψ und/oder die zweite Kippachse Φ vom Piezopositionierer 1 kompensiert werden.

Zur Steuerung der restlichen Vorrichtung ist eine Kontrolleinheit vorgesehen, die die Signale von den Distanzsensoren X1, X2, Y1, Y2, Z1, Z2, Z3 empfängt und den Piezopositionierer entsprechend steuert, um Abweichungen des Probenträgers 2 von vorbestimmten Werten zu beheben.

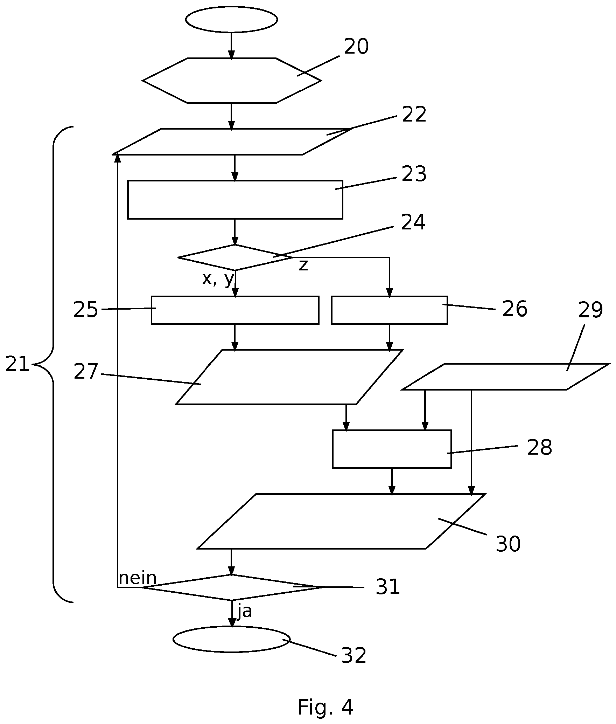

Fig. 4 veranschaulicht in einem Flussdiagramm eine bevorzugte Ausführungsform des Verfahrens zur Störgrößenkompensation. Zuerst kann eine Ausrichtung und Kalibration der Achsen erfolgen 20. Anschließend erfolgt eine Regelkreissteuerung 21, die die folgenden Schritte umfasst:
- Messen 22 der Distanzen dx1, dx2, dy1, dy2, dz1, dz2, dz3 mit dem ersten bis siebten Distanzsensor X1, X2, Y1, Y2, Z1, Z2, Z3 entlang der zugehörigen ersten Achse x, zweiten Achse y bzw. dritten Achse z und Auslesen der Distanzsensoren X1, X2, Y1, Y2, Z1, Z2, Z3;
- Zuordnen 23 der Datenkanäle zu den jeweiligen Achsen x, y, z und Ausrichtung am Koordinatensystem des Piezopositionierers 1;
- Unterscheidung 24 nach den Achsentypen, wobei im Falle der ersten Achse x und der zweiten Achse y die Position und die thermische Ausdehnung des Probenträgers 2 in Richtung der jeweiligen Achse x, y bestimmt werden 25 und im Falle der dritten Achse z die Position des Probenträgers 2 in Richtung der dritten Achse bestimmt wird 26 und die Kippwinkel um die erste Kippachse Ψ und um die zweite Kippachse Φ bestimmt werden;
- Darstellung 27 der bestimmten Daten (Position, Ausdehnung und Kippwinkel) und Logging der Daten;
- zur aktiven Positionskontrolle erfolgt 28 ein Vergleich der Daten mit vorbestimmten Sollwerten 29 und darauf basierend das Setzen 30 neuer Positionsdaten für den Piezopositionierer 1
- Entscheiden 31, ob das Verfahren beendet werden 32 soll oder die Schritte wiederholt werden sollen.

## Patentansprüche

1. Verfahren zur Störgrößenkompensation bei der Positionierung eines Probenträgers (2), insbesondere bei der Sondenmikroskopie, aufweisend die Schritte:
Messung einer Distanz (dx1) mit einem ersten Distanzsensor (X1) eines Sensorträgers (3) zu einer ersten Seite des Probenträgers (2) und einer Distanz (dx2) mit einem zweiten Distanzsensor (X2) des Sensorträgers (3) zu einer der ersten Seite gegenüberliegenden zweiten Seite des Probenträgers (2), wobei die Distanzen (dx1, dx2) im Wesentlichen parallel zu einer ersten Achse (x) bestimmt werden;
Messung einer Distanz (dy1) mit einem dritten Distanzsensor (Y1) des Sensorträgers (3) zu einer dritten Seite des Probenträgers (2) und einer Distanz (dy2) mit einem vierten Distanzsensor (Y2) des Sensorträgers (3) zu einer der dritten Seite gegenüberliegenden vierten Seite des Probenträgers (2), wobei die Distanzen (dy1, dy2) im Wesentlichen parallel zu einer von der ersten Achse (x) verschiedenen zweiten Achse (y) bestimmt werden;
Bestimmen der Position und der Ausdehnung des Probenträgers (2) entlang der ersten Achse (x) aus den Distanzen (dx1, dx2) parallel zu der ersten Achse (x) und/oder Bestimmen der Position und der Ausdehnung des Probenträgers (2) entlang der zweiten Achse (y) aus den Distanzen (dy1, dy2) parallel zu der zweiten Achse (y);
Positionieren des Probenträgers (2) relativ zum Sensorträger (3) mit einem Piezopositionierer (1), wobei auf Grundlage der bestimmten Position und Ausdehnung Störgrößen kompensiert werden.

2. Verfahren nach dem vorhergehenden Anspruch, weiter aufweisend die Schritte:
Messung einer Distanz (dz1) zum Probenträger (2) mit einem fünften Distanzmesser (Z1) des Sensorträgers (3), wobei die Distanz (dz1) im Wesentlichen parallel zu einer dritten Achse (z) bestimmt wird, die von der ersten Achse (x) und der zweiten Achse (y) verschieden ist.

3. Verfahren nach Anspruch 2, wobei die Position des Probenträgers (2) entlang der dritten Achse (z) bestimmt wird.

4. Verfahren nach Anspruch 2 oder 3, weiter aufweisend die Schritte:
Messung einer Distanz (dz2, dz3) zum Probenträger (2) mit einem sechsten Distanzmesser (Z2) des Sensorträgers (3) und mit einem siebten Distanzmesser (Z3) des Sensorträgers (3), wobei die Distanzen (dz2, dz3) im Wesentlichen parallel zu der dritten Achse (z) bestimmt werden, wobei vorzugsweise eine Verkippung um eine erste Kippachse (Ψ) des Probenträgers (2) aus den vom sechsten Distanzmesser (Z2) und vom siebten Distanzmesser (Z3) bestimmten Distanzen (dz2, dz3) bestimmt wird und/oder eine Verkippung um eine zweite Kippachse (Φ) des Probenträgers (2) aus den vom fünften Distanzmesser (Z1), sechsten Distanzmesser (Z2) und siebten Distanzmesser (Z3) bestimmten Distanzen (dz1, dz2, dz3) bestimmt wird.

5. Verfahren nach einem der vorhergehenden Ansprüche, wobei eine Regelkreissteuerung erfolgt, wobei mit dem Piezopositionierer (1) Störgrößen in der Positionierung des Probenträgers (2) kompensiert werden auf Grundlage
der mit dem ersten Distanzsensor (X1) und mit dem zweiten Distanzsensor (X2) bestimmten Distanzen (dx1, dx2) parallel zu der ersten Achse (x), insbesondere der bestimmten Position und Ausdehnung des Probenträgers (2) entlang der ersten Achse (x), und
der mit dem dritten Distanzsensor (Y1) und mit dem vierten Distanzsensor (Y2) bestimmten Distanzen (dy1, dy2) parallel zu der zweiten Achse (y), insbesondere der bestimmten Position und Ausdehnung des Probenträgers (2) entlang der zweiten Achse (y) und
optional der mit dem fünften Distanzsensor (Z1) und/oder sechsten Distanzsensor (Z2) und/oder siebten Distanzsensor (Z3) bestimmten Distanzen (dz1, dz2, dz3) parallel zu der dritten Achse (z).

6. Verfahren nach Anspruch 4 und Anspruch 5, wobei die Regelkreissteuerung umfasst, dass eine Verkippung des Probenträgers (2) um die erste Kippachse (Ψ) und/oder die zweite Kippachse (Φ) vom Piezopositionierer (1) kompensiert werden.

7. Verfahren nach einem der vorhergehenden Ansprüche, wobei die erste Achse (x) im Wesentlichen orthogonal zur zweiten Achse (y) ist und vorzugsweise die erste Achse (x) im Wesentlichen orthogonal zur dritten Achse (z) ist und vorzugsweise die zweite Achse (y) im Wesentlichen orthogonal zur dritten Achse (z) ist.

8. Verfahren nach einem der vorhergehenden Ansprüche, wobei die erste Achse (x) und die zweite Achse (y) im Wesentlichen horizontal verlaufen und vorzugsweise die dritte Achse (z) im Wesentlichen vertikal verläuft.

9. Verfahren nach einem der vorhergehenden Ansprüche, wobei der erste Distanzsensor (X1), der zweite Distanzsensor (X2), der dritte Distanzsensor (Y1) und der vierte Distanzsensor (Y2) jeweils mit einer Erfassungsrate von zwischen 1 Hz und 1 MHz betrieben werden und die Positionierung des Probenträgers (2) durch den Piezopositionierer (1) mit einer Ansteuerungsrate von zwischen 1 Hz und 1 MHz erfolgt.

10. Verfahren nach einem der vorhergehenden Ansprüche, wobei der Probenträger (2) eine Probe trägt und der Sensorträger (3) eine Sonde zur Wechselwirkung mit der Probe trägt.

11. Vorrichtung (10) zur Störgrößenkompensation bei der Positionierung eines Probenträgers (2) aufweisend:
- den Probenträger (2);
- einen Sensorträger (3) mit
einem ersten Distanzsensor (X1) zur Messung der Distanz (dx1) zu einer ersten Seite des Probenträgers (2) und einem zweiten Distanzsensor (X2) zur Messung der Distanz (dx2) zu einer der ersten Seite gegenüberliegenden zweiten Seite des Probenträgers (2),
einem dritten Distanzsensor (Y1) zur Messung der Distanz (dy1) zu einer dritten Seite des Probenträgers (2) und einem vierten Distanzsensor (Y2) zur Messung der Distanz (dy2) zu einer der dritten Seite gegenüberliegenden vierten Seite des Probenträgers (2),
wobei der erste und der zweite Distanzsensor (X1, X2) zur Bestimmung der Distanzen (dx1, dx2) im Wesentlichen parallel zu einer ersten Achse (x) eingerichtet sind und der dritte und der vierte Distanzsensor (Y1, Y2) zur Bestimmung der Distanzen (dy1, dy2) im Wesentlichen parallel zu einer von der ersten Achse (x) verschiedenen zweiten Achse (y) eingerichtet sind; und
- einen Piezopositionierer (1), der den Probenträger (2) trägt,
- eine Kontrolleinheit, wobei die Vorrichtung (10) dazu eingerichtet ist, das Verfahren nach einem der Ansprüche 1 bis 10 auszuführen.

12. Vorrichtung (10) nach Anspruch 11, wobei der erste Distanzsensor (X1), zweite Distanzsensor (X2), dritte Distanzsensor (Y1) und/oder vierte Distanzsensor (Y2) jeweils ein kapazitativer Distanzsensor oder ein interferometrischer Distanzsensor sind.

13. Vorrichtung (10) nach Anspruch 12, wobei der erste Distanzsensor (X1), zweite Distanzsensor (X2), dritte Distanzsensor (Y1) und/oder vierte Distanzsensor (Y2) jeweils ein laserinterferometrischer Distanzsensor sind.

14. Vorrichtung (10) nach einem der Ansprüche 11 bis 13, wobei der Sensorträger (3) aufweist:
einen fünften Distanzsensor (Z1) zur Messung der Distanz (dz1) zum Probenträger (2),
vorzugsweise einen sechsten Distanzsensor (Z2) zur Messung der Distanz (dz2) zum Probenträger (2),
vorzugsweise einen siebten Distanzsensor (Z3) zur Messung der Distanz (dz3) zum Probenträger (2),
wobei der fünfte Distanzsensor (Z1), vorzugsweise der sechste Distanzsensor (Z2) und vorzugsweise der siebte Distanzsensor (Z3) zur Bestimmung der Distanzen (dz1, dz2, dz3) im Wesentlichen parallel zu einer dritten Achse (z) eingerichtet sind, die von der ersten Achse (x) und der zweiten Achse (y) verschieden ist.

## Claims

1. A method for interference variable compensation during the positioning of a sample support (2), in particular during probe microscopy, comprising the following steps:
measuring a distance (dx1) with a first distance sensor (X1) of a sensor support (3) to a first side of the sample support (2) and measuring a distance (dx2) with a second distance sensor (X2) of the sensor support (3) to a second side of the sample support (2) opposite the first side, wherein the distances (dx1, dx2) are determined substantially in parallel to a first axis (x);
measuring a distance (dy1) with a third distance sensor (Y1) of the sensor support (3) to a third side of the sample support (2) and measuring a distance (dy2) with a fourth distance sensor (Y2) of the sensor support (3) to a fourth side of the sample support (2) opposite the third side, wherein the distances (dy1, dy2) are determined substantially in parallel to a second axis (y) different from the first axis (x);
determining the position and the extent of the sample support (2) along the first axis (x) from the distances (dx1, dx2) parallel to the first axis (x), and/or determining the position and the extent of the sample support (2) along the second axis (y) from the distances (dy1, dy2) parallel to the second axis (y);
positioning the sample support (2) relative to the sensor support (3) using a piezo positioner (1), wherein based on the determined position and extent interference variables are compensated.

2. The method according to the preceding claim, further comprising the following steps:
measuring a distance (dz1) to the sample support (2) using a fifth distance meter (Z1) of the sensor support (3), wherein the distance (dz1) being determined substantially in parallel to a third axis (z) different from the first axis (x) and the second axis (y).

3. The method according to claim 2, wherein the position of the sample support (2) is determined along the third axis (z).

4. The method according to claim 2 or 3, further comprising the following steps:
measuring a distance (dz2, dz3) to the sample support (2) with a sixth distance meter (Z2) of the sensor support (3) and with a seventh distance meter (Z3) of the sensor support (3), wherein the distances (dz2, dz3) are determined substantially in parallel to the third axis (z), wherein preferably a tilting about a first tilting axis (Ψ) of the sample support (2) is determined from the distances (dz2, dz3) determined by the sixth distance meter (Z2) and by the seventh distance meter (Z3) and/or a tilting about a second tilting axis (Φ) of the sample support (2) is determined from the distances (dz1, dz2, dz3) determined by the fifth distance meter (Z1), sixth distance meter (Z2) and seventh distance meter (Z3).

5. The method according to any one of the preceding claims, wherein a closed-loop control is carried out, wherein interference variables in the positioning of the sample support (2) are compensated for with the piezo positioner on the basis of
the distances (dx1, dx2) determined with the first distance sensor (X1) and with the second distance sensor (X2) parallel to the first axis (x), in particular the determined position and extent of the sample support (2) along the first axis (x), and
the distances (dy1, dy2) determined with the third distance sensor (Y1) and with the fourth distance sensor (Y2) parallel to the second axis (y), in particular the determined position and extent of the sample support (2) along the second axis (y) and
optionally the distances (dz1, dz2, dz3) determined with the fifth distance sensor (Z1) and/or sixth distance sensor (Z2) and/or seventh distance sensor (Z3) parallel to the third axis (z).

6. The method according to claim 4 and claim 5, wherein the closed-loop control comprises compensating for tilting of the sample support (2) about the first tilt axis (Ψ) and/or the second tilt axis (Φ) by the piezo positioner (1).

7. The method according to any one of the preceding claims, wherein the first axis (x) is substantially orthogonal to the second axis (y) and preferably the first axis (x) is substantially orthogonal to the third axis (z) and preferably the second axis (y) is substantially orthogonal to the third axis (z).

8. The method according to any one of the preceding claims, wherein the first axis (x) and the second axis (y) run substantially horizontal and preferably the third axis (z) runs substantially vertical.

9. The method according to any one of the preceding claims, wherein the first distance sensor (X1), the second distance sensor (X2), the third distance sensor (Y1) and the fourth distance sensor (Y2) are each operated at a detection rate of between 1 Hz and 1 MHz and the positioning of the sample support (2) by the piezo positioner (1) takes place at a control rate of between 1 Hz and 1 MHz.

10. The method according to any one of the preceding claims, wherein the sample support (2) carries a sample and the sensor support (3) carries a probe for interacting with the sample.

11. A device (10) for interference variable compensation during the positioning of a sample support (2) comprising:
- the sample support (2);
- a sensor support (3) with
a first distance sensor (X1) for measuring the distance (dx1) to a first side of the sample support (2) and a second distance sensor (X2) for measuring the distance (dx2) to a second side of the sample support (2) opposite the first side,
a third distance sensor (Y1) for measuring the distance (dy1) to a third side of the sample support (2) and a fourth distance sensor (Y2) for measuring the distance (dy2) to a fourth side of the sample support (2) opposite the third side,
wherein the first and second distance sensors (X1, X2) are configured to determine the distances (dx1, dx2) substantially in parallel to a first axis (x), and the third and fourth distance sensors (Y1, Y2) are configured to determine the distances (dy1, dy2) substantially in parallel to a second axis (y) different from the first axis (x); and
- a piezo positioner (1) that carries the sample support (2).
- a control unit, wherein the device (10) is configured to carry out the method according to any one of claims 1 to 10.

12. The device (10) according to claim 11, wherein the first distance sensor (X1), second distance sensor (X2), third distance sensor (Y1) and/or fourth distance sensor (Y2) are each a capacitive distance sensor or an interferometric distance sensor.

13. The device (10) according to claim 12, wherein the first distance sensor (X1), second distance sensor (X2), third distance sensor (Y1) and/or fourth distance sensor (Y2) are each a laser interferometric distance sensor.

14. The device (10) according to any one of claims 11 to 13, wherein the sensor support (3) comprises:
a fifth distance sensor (Z1) for measuring the distance (dz1) to the sample support (2),
preferably a sixth distance sensor (Z2) for measuring the distance (dz2) to the sample support (2),
preferably a seventh distance sensor (Z3) for measuring the distance (dz3) to the sample support (2),
wherein the fifth distance sensor (Z1), preferably the sixth distance sensor (Z2), and preferably the seventh distance sensor (Z3) are configured to determine the distances (dz1, dz2, dz3) substantially in parallel to a third axis (z) different from the first axis (x) and the second axis (y).

## Revendications

1. Procédé de compensation des perturbations lors du positionnement d'un porte-échantillon (2), en particulier en microscopie à sonde, comprenant les étapes suivantes :
mesure d'une distance (dx1) avec un premier capteur de distance (X1) d'un support de capteurs (3) vers un premier côté du porte-échantillon (2) et d'une distance (dx2) avec un deuxième capteur de distance (X2) du support de capteurs (3) vers un deuxième côté du porte-échantillon (2) opposé au premier côté, les distances (dx1, dx2) étant déterminées de manière essentiellement parallèle à un premier axe (x) ;
mesure d'une distance (dy1) avec un troisième capteur de distance (Y1) du support de capteurs (3) vers un troisième côté du porte-échantillon (2) et d'une distance (dy2) avec un quatrième capteur de distance (Y2) du support de capteurs (3) vers un quatrième côté du porte-échantillon (2) opposé au troisième côté, les distances (dy1, dy2) étant déterminées de manière essentiellement parallèle à un deuxième axe (y) différent du premier axe (x) ;
détermination de la position et de l'étendue du porte-échantillon (2) le long du premier axe (x) à partir des distances (dx1, dx2) parallèles au premier axe (x) et/ou détermination de la position et de l'étendue du porte-échantillon (2) le long du deuxième axe (y) à partir des distances (dy1, dy2) parallèles au deuxième axe (y) ;
positionnement du porte-échantillon (2) par rapport au support de capteurs (3) avec un positionneur piézoélectrique (1), les perturbations étant compensées sur la base de la position et de l'étendue déterminées.

2. Procédé selon la revendication 1, comprenant en outre les étapes suivantes :
mesure d'une distance (dz1) jusqu'au porte-échantillon (2) avec un cinquième capteur de distance (Z1) du support de capteurs (3), la distance (dz1) étant déterminée de manière essentiellement parallèle à un troisième axe (z) qui est différent du premier axe (x) et du deuxième axe (y).

3. Procédé selon la revendication 2, dans lequel la position du porte-échantillon (2) le long du troisième axe (z) est déterminée.

4. Procédé selon la revendication 2 ou 3, comprenant en outre les étapes suivantes :
mesure d'une distance (dz2, dz3) jusqu'au porte-échantillon (2) avec un sixième capteur de distance (Z2) du support de capteurs (3) et avec un septième capteur de distance (Z3) du support de capteurs (3), les distances (dz2, dz3) étant déterminées de manière essentiellement parallèle au troisième axe (z), de préférence une inclinaison autour d'un premier axe d'inclinaison (Ψ) du porte-échantillon (2) étant déterminée à partir des distances (dz2, dz3) déterminées par le sixième capteur de distance (Z2) et le septième capteur de distance (Z3) et/ou une inclinaison autour d'un deuxième axe d'inclinaison (Φ) du porte-échantillon (2) étant déterminée à partir des distances (dz1, dz2, dz3) déterminées par le cinquième capteur de distance (Z1), le sixième capteur de distance (Z2) et le septième capteur de distance (Z3).

5. Procédé selon l'une des revendications précédentes, dans lequel un contrôle en boucle fermée est effectué, les perturbations dans le positionnement du porte-échantillon (2) étant compensées par le positionneur piézoélectrique (1) sur la base
des distances (dx1, dx2) déterminées par le premier capteur de distance (X1) et le deuxième capteur de distance (X2) parallèlement au premier axe (x), en particulier de la position et de l'étendue déterminées du porte-échantillon (2) le long du premier axe (x), et
des distances (dy1, dy2) déterminées par le troisième capteur de distance (Y1) et le quatrième capteur de distance (Y2) parallèlement au deuxième axe (y), en particulier de la position et de l'étendue déterminées du porte-échantillon (2) le long du deuxième axe (y) et
optionnellement des distances (dz1, dz2, dz3) déterminées par le cinquième capteur de distance (Z1) et/ou le sixième capteur de distance (Z2) et/ou le septième capteur de distance (Z3) parallèlement au troisième axe (z).

6. Procédé selon la revendication 4 et la revendication 5, dans lequel le contrôle en boucle fermée comprend la compensation par le positionneur piézoélectrique (1) d'une inclinaison du porte-échantillon (2) autour du premier axe d'inclinaison (Ψ) et/ou du deuxième axe d'inclinaison (Φ).

7. Procédé selon l'une des revendications précédentes, dans lequel le premier axe (x) est essentiellement orthogonal au deuxième axe (y) et de préférence le premier axe (x) est essentiellement orthogonal au troisième axe (z) et de préférence le deuxième axe (y) est essentiellement orthogonal au troisième axe (z).

8. Procédé selon l'une des revendications précédentes, dans lequel le premier axe (x) et le deuxième axe (y) sont essentiellement horizontaux et de préférence le troisième axe (z) est essentiellement vertical.

9. Procédé selon l'une des revendications précédentes, dans lequel le premier capteur de distance (X1), le deuxième capteur de distance (X2), le troisième capteur de distance (Y1) et le quatrième capteur de distance (Y2) sont chacun fonctionnent à une fréquence d'acquisition comprise entre 1 Hz et 1 MHz et le positionnement du porte-échantillon (2) par le positionneur piézoélectrique (1) est effectué avec une fréquence de commande comprise entre 1 Hz et 1 MHz.

10. Procédé selon l'une des revendications précédentes, dans lequel le porte-échantillon (2) porte un échantillon et le support de capteurs (3) porte une sonde destinée à interagir avec l'échantillon.

11. Dispositif (10) de compensation des perturbations lors du positionnement d'un porte-échantillon (2) comprenant :
- le porte-échantillon (2) ;
- un support de capteurs (3) avec
un premier capteur de distance (X1) pour mesurer la distance (dx1) jusqu'à un premier côté du porte-échantillon (2) et un deuxième capteur de distance (X2) pour mesurer la distance (dx2) jusqu'à un deuxième côté du porte-échantillon (2) opposé au premier côté,
un troisième capteur de distance (Y1) pour mesurer la distance (dy1) jusqu'à un troisième côté du porte-échantillon (2) et un quatrième capteur de distance (Y2) pour mesurer la distance (dy2) jusqu'à un quatrième côté du porte-échantillon (2) opposé au troisième côté,
le premier et le deuxième capteur de distance (X1, X2) étant configurés pour déterminer les distances (dx1, dx2) de manière essentiellement parallèle à un premier axe (x) et le troisième et le quatrième capteur de distance (Y1, Y2) étant configurés pour déterminer les distances (dy1, dy2) de manière essentiellement parallèle à un deuxième axe (y) différent du premier axe (x) ; et
- un positionneur piézoélectrique (1) qui supporte le porte-échantillon (2),
- une unité de contrôle, le dispositif (10) étant configuré pour exécuter le procédé selon l'une des revendications 1 à 10.

12. Dispositif (10) selon la revendication 11, dans lequel le premier capteur de distance (X1), le deuxième capteur de distance (X2), le troisième capteur de distance (Y1) et/ou le quatrième capteur de distance (Y2) sont chacun un capteur de distance capacitif ou un capteur de distance interférométrique.

13. Dispositif (10) selon la revendication 12, dans lequel le premier capteur de distance (X1), le deuxième capteur de distance (X2), le troisième capteur de distance (Y1) et/ou le quatrième capteur de distance (Y2) sont chacun un capteur de distance interférométrique laser.

14. Dispositif (10) selon l'une des revendications 11 à 13, dans lequel le support de capteurs (3) comprend :
un cinquième capteur de distance (Z1) pour mesurer la distance (dz1) jusqu'au porte-échantillon (2),
de préférence un sixième capteur de distance (Z2) pour mesurer la distance (dz2) jusqu'au porte-échantillon (2),
de préférence un septième capteur de distance (Z3) pour mesurer la distance (dz3) jusqu'au porte-échantillon (2),
le cinquième capteur de distance (Z1), de préférence le sixième capteur de distance (Z2) et de préférence le septième capteur de distance (Z3) étant configurés pour déterminer les distances (dz1, dz2, dz3) de manière essentiellement parallèle à un troisième axe (z) qui est différent du premier axe (x) et du deuxième axe (y).
